# EUROPEAN PATENT SPECIFICATION

(11) **EP 2 277 779 B1**
(45) Date of publication and mention of the grant of the patent: **17.04.2013**
(21) Application number: 10251308.2
(22) Date of filing: 22.07.2010
(51) Int. Cl.: B65B 5/04, B65B 35/16, C30B 35/00

(54) **Crane device for wrapped quartz glass crucible and method of packing wrapped quartz glass crucible using the device**
Kranvorrichtung für umhüllte Quarzglastiegel und Verfahren zum Verpacken des umhüllten Quarzglastiegels mit Hilfe der Vorrichtung
Dispositif de grue pour un creuset en verre de quartz enveloppé et procédé de conditionnement du creuset en verre de quartz enveloppé utilisant le dispositif

(30) Priority: 22.07.2009 JP 2009171485; 29.06.2010 JP 2010147511
(43) Date of publication of application: 26.01.2011
(73) Proprietor: Japan Super Quartz Corporation, Akita-shi Akita 010-0065 (JP)
(72) Inventor: Shonai, Manabu, Akita-shi Akita 010-0065 (JP); Sato, Taira, Akita-shi Akita 010-0065 (JP); Shirakawa, Minoru, Akita-shi Akita 010-0065 (JP); Ikehata, Shuichi, Akita-shi Akita 010-0065 (JP); Takahashi, Hiroshi, Akita-shi Akita 010-0065 (JP)
(74) Representative: Gulde Hengelhaupt Ziebig & Schneider

(56) References cited:
- JP-A- 6 239 632
- JP-A- 7 172 975
- JP-A- 7 206 580
- JP-A- 2002 029 886
- JP-A- 2008 297 186

## Description

### BACKGROUND OF THE INVENTION

Field of the Invention

The present invention relates to a crane device for transferring a quartz glass crucible, especially a wrapped quartz glass crucible, for use, for example, in pulling up single crystal silicon and a method of packing a quartz glass crucible using the crane device.

Description of the Related Art

In general, after being manufactured, a quartz glass crucible (hereinafter, also referred to simply as a "crucible") is washed, subjected to an inspection step and then packed and shipped. Recently, as the required purity of semiconductor materials increases, efforts have been made to minimize contamination of the crucible itself, which is directly used to manufacture the semiconductor material. For example, when a crucible is to be used to pull up single crystal silicon, the crucible is washed further by using ultrapure water or the like prior to use. On the other hand, to increase the manufacturing efficiency of single crystal silicon, the size of a crucible is becoming larger. However, it is difficult to handle such a large diameter crucible and thus such a crucible is susceptible to contamination, especially, contamination caused by entry of powders remaining in the outer peripheral portion of the crucible into the inner peripheral portion thereof during the step of inspection or packing after manufacture.

In order to avoid such a problem of contamination as described above, it is effective to mechanically wrap, without involving manual work, a crucible in a clean state after being washed. However, it is not necessarily easy to wrap a large-size crucible. Contamination in the inner peripheral portion of the crucible must especially be avoided as best as possible, but substances attaching on the outer periphery of the crucible may enter the inner peripheral portion of the crucible if the crucible as a whole is simply packed in a bag. If this happens, the inner peripheral portion can no longer be kept in a clean state. Furthermore, there exists a possibility that the inner portion of a crucible is contaminated during a period from unwrapping the entire crucible to disposing the crucible on a lifting-up device.

As a technique for solving the problems as described above, JP 2001-010611 Laid-Open proposes an automatic washing and sealing device of a crucible, capable of washing and drying a crucible, followed by automatically sealing at least an opening portion of the clean crucible and inserting the crucible into a bag-shaped plastic sheet for wrapping. Since this device mechanically carries out processes of sealing an opening portion of the crucible and putting the sealed crucible into a bag, contamination in the inner peripheral portion of the crucible can be prevented from occurring over a period of time from unwrapping of the wrapped crucible to setting the crucible on a lifting-up device.

### SUMMARY OF THE INVENTION

The crucible which has been wrapped as described above is generally subjected to a packing process in which the crucible is accommodated in a container such as a corrugated cardboard box or a wooden box, and then shipped. During this packing process, it is necessary to handle a crucible that has been put into a bag such as a polyethylene bag, that is, a crucible which easily slips on the bag. Accordingly, the crucible has to be transferred into a container basically by manual operation in which two or more operators hold the crucible and deliver it into the container.

This operation imposes relatively large load on workers especially when a large-size crucible is handled, and hence there has been a demand for improving the packing operation in this regard. Further, since the cleanliness on the outer side of the wrap has been generally improved as a result of automation achieved up to the wrapping process of the crucible, it is desirable to avoid any manual packing operation thereafter which may induce contamination and thus runs counter to the purpose of mechanical wrapping. That is, there has been a demand for improving the packing operation for this cleaness reason, as well. Crane devices for handling wrapped crucibles are known from JP 2002-029886.

An object of the present invention is to provide a crane device suitable for handling a wrapped crucible, which crane device is capable of realizing mechanical handling of the wrapped crucible by way of a machine without manual work, and a method of packing a wrapped crucible by using the crane device.

A primary configuration of the present invention is as follows:
(1) A crane device provided to be capable of making reciprocal movements along a path between a position above a lifting-up point where a wrapped quartz glass crucible is placed and another position above a putting-down point where a packing container is placed and ascending to/descending from the path at each of the lifting-up point and the putting-down point, has: four arms extending in the ascend-descend direction and disposed at apexes of a quadrangle such that two arms paired on a diagonal line of the quadrangle are movable to advance by sliding along the diagonal line to separate from each other; and a claw provided at a rear end of each arm to extend in the advancing direction of the arm.
(2) A method of packing a wrapped quartz glass crucible by lifting up a wrapped quartz glass crucible by a crane device, moving the crane device to a quadrangular-prism-shaped packing container, and lowering the quartz glass crucible inside the packing container, includes: preparing a crane device having: four arms extending in the lifting-up direction of the wrapped quartz glass crucible and disposed at apexes of a quadrangle corresponding to the four corners of the packing container such that two arms paired on a diagonal line of the quadrangle are movable to advance by sliding along the diagonal line to separate from each other; and a claw provided at a rear end of each arm to extend in the advancing direction of the arm; supporting the bottom of the wrapped quartz glass crucible by the claws, while the four arms are kept in a state not in contact with the wrap of the crucible; and lifting up and moving the wrapped quartz glass crucible, and then putting it down, thereby loading the quartz glass crucible into the packing container.

According the present invention, a crane device suitable, especially, for a wrapped crucible which is generally difficult to handle can be provided. Therefore, a packing operation of a wrapped crucible, which conventionally necessitates manual work, can be mechanized by using the crane device, whereby not only the operational efficiency is enhanced but also a packing operation can be conducted under a clean environment, which significantly contributes to maintaining a high degree of cleanliness at the outer side of the wrap.

### BRIEF DESCRIPTION OF THE DRAWINGS

FIG. 1 is a plan view of a place where a crane device is provided.
FIG. 2 is a side view of the place where the crane device is provided.
FIG. 3 is a perspective view showing main parts of the crane device.
FIG. 4 is a plan view showing movement of arms and claws of the crane device in the packing container.
Fig. 5 is a side view showing movement of the arm and claw of the crane device.

### DESCRIPTION OF THE PREFERRED EMBODIMENTS

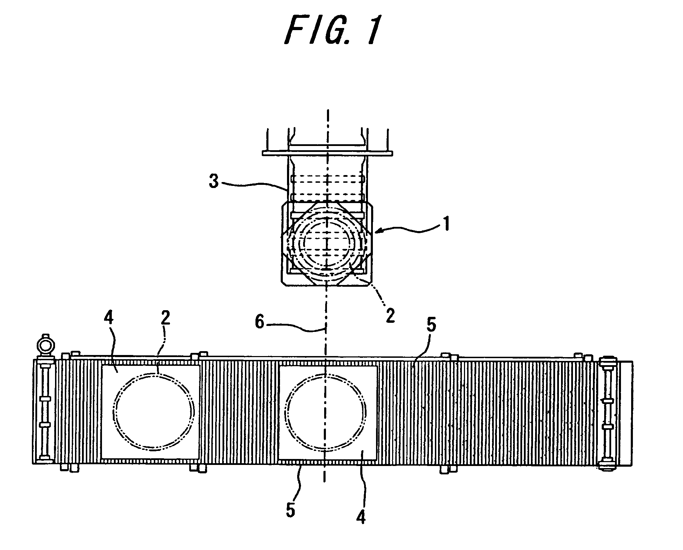

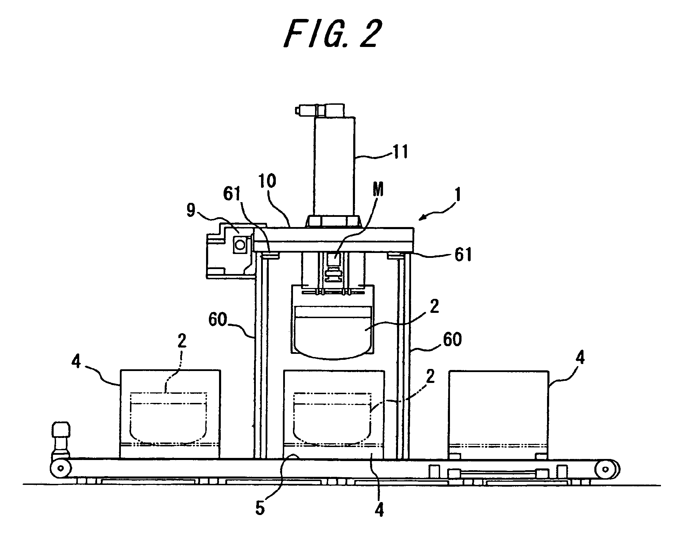

Hereinbelow, a crane device of the present invention will be described in detail with reference to the drawings.
First, as shown in FIGS. 1 and 2, a crane device 1 of the present invention is provided to be capable of: making reciprocal movements along a path 6 between a position above a lifting-up point 3 where a wrapped quartz glass crucible 2 is placed (for example, an endpoint of a transporting conveyor from a wrapping operation) and another position above a putting-down point 5 where a packing container 4 is placed (for example, an intermediate point of a transporting conveyor to a final packing operation); and ascending to/descending from the path 6 at each of the lifting-up point 3 and the putting-down point 5.

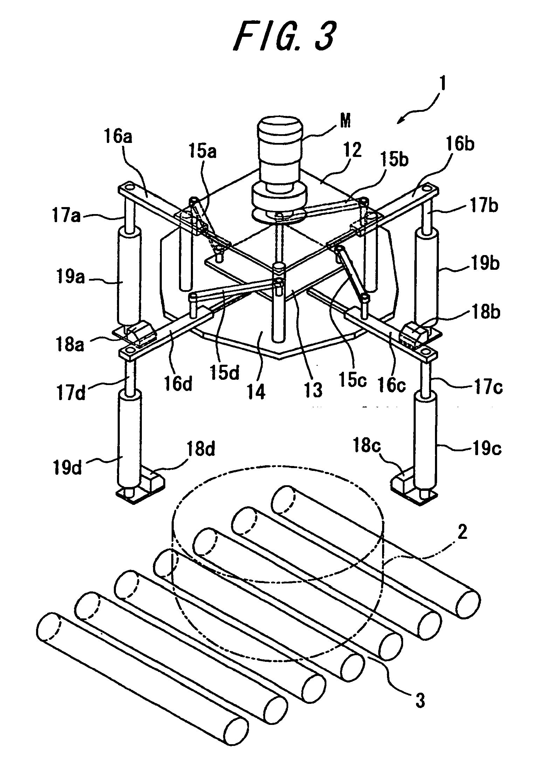

As shown in FIG. 2, in the crane device 1, rails 61 forming the path 6 extend between columns 60 disposed at each of the lifting-up point 3 and the putting-down point 5, and a frame 10 is mounted on the rails 61 so as to be able to make reciprocal movement along the rails 61 by a transfer mechanism 9. As shown in FIG. 3, supporting plates (three in the shown example) 12, 13, 14 layered by spacing apart from each other are suspendingly connected to the frame 10 by way of an elevation mechanism 11 such that the supporting plates can ascend/descend relative to the frame 10. Link mechanisms 15a-15d are disposed between the supporting plates 12, 13, and sliders 16a-16d are provided on the supporting plate 14. Four arms 17a-17d extending in the ascending/descending direction are attached to the supporting plate by way of the linkage mechanisms 15a-15d and the slider 16a-16d.

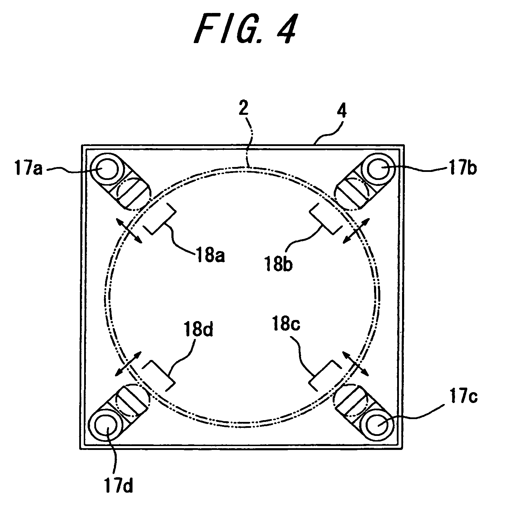

In the present embodiment, as shown in FIG. 4, it is important that the four arms 17a-17d are disposed at the apexes of the quadrangle corresponding to the four corners of a quadrangular-prism-shaped packing container 4, and that the two arms 17a and 17c paired on a diagonal line, as well as the two arms 17b and 17d paired on the other diagonal line, of the quadrangle are provided to be movable to advance to/separate from each other through the linkage mechanisms 15a-15d and the sliders 16a-16d. The linkage mechanisms 15a-15d, driven by a motor M, transfer the aforementioned movements to the arms 17a-17d. Further, each of the arms 17a-17d has a claw 18a-18d provided at the rear end thereof to extend in the advancing direction of the arm. Yet further, cushion members 19a-19d are wound around an outer periphery of the arms 17a-17d.

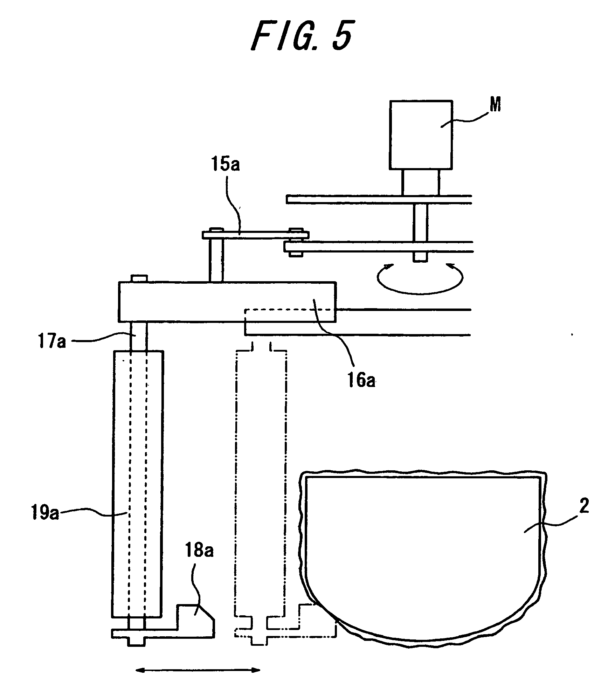

As shown in FIGS. 1 and 2, the crane device 1 structured as described above is used to lift up the wrapped crucible 2, transfer the raised wrapped crucible 2 to the quadrangular-prism-shaped packing container 4, and put down the crucible 2 in the packing container 4.
Regarding lifting up the wrapped crucible 2 by the crane device 1, first the crane device 1 is moved to the lift-up point 3, and at this point, the supporting plates 12, 13, 14 are moved downward relative to the frame 10 through the elevation mechanism 11. At this time, the arms 17a-17d and the claws 18a-18d are caused to retreat to positions that do not interfere with the wrapped crucible 2 by operating the linkage mechanisms 15a-15d by the motor M. When the claws 18a-18d at the rear end portions of the arms 17a-17d are lowered and reached a surface of the wrapped crucible 2 at which surface the crucible is placed on a stage, the lowering operation is stopped. Then, the linkage mechanisms 15a-15d are operated by using the motor M such that the arms 17a-17d advance toward an axial center of the wrapped crucible 2 as shown in FIG. 5, and this advancing movement of the arms 17a-17d is stopped when the claws 18a-18d are brought into contact with the vicinity of an edge portion of the bottom surface of the wrapped crucible 2. In the present embodiment, it is important to keep the arms 17a-17d in a state not in contact with the wrap of the crucible, as shown in FIG. 5, in terms of suppressing contamination at the outer side of the wrap.

Next, the supporting plates 12, 13, 14 are elevated through the elevation mechanism 11 toward the frame 10, such that the wrapped crucible 2, held at the four corners thereof by the claws 18a-18d of the four arms 17a-17d, is lifted up. Thereafter, the crane device 1 is horizontally moved along the path 6 to the putting-down point 5 where the packing container 4 is placed. After the crane device 1 has reached the putting-down point 5, the supporting plates 12, 13, 14 are moved downward through the elevation mechanism 11 from the frame 10 to the packing container 4. At this time, since the arms 17a-17d are disposed at the apexes of the quadrangle corresponding to the four corners of the packing container 4, the arms 17a-17d can be adroitly accommodated in largest gap spaces among those created between the wrapped crucible 2 and the packing container 4, as shown in FIG. 4. The arms 17a-17d can each have a relatively large range of movement, as shown in arrow in FIG. 4, by inserting the arms 17a-17d to these largest gap spaces, whereby the arms 17a-17d and the claws 18a-18d can advance/retreat with respect to the wrapped crucible 2, as shown in FIG. 5.

Accordingly, it can be realized that the bottom surface of the wrapped crucible 2 is supported by the claws 18a-18d in a state where the arms 17a-17d are not in contact with the wrap of the wrapped crucible 2. Further, since the arms 17a-17d are accommodated at the four corners of the packing container 4, lengths of the sides of the packing container 4 can be set closer to a diameter of an opening of the crucible to be accommodated, which contributes to space-efficient designing of the packing container 4.

The wrapped crucible 2 is lowered in a state where it is supported as described above. Upon the bottom surface of the crucible 2 reaching the bottom surface on the inner side of the packing container 4, the lowering operation of the wrapped crucible 2 is stopped. Then, the linkage mechanisms 15a-15d are operated such that the arms 17a-17d and the claws 18a-18d retreat from the wrapped crucible 2, as shown in FIG. 4. Thereafter, the supporting plates 12, 13, 14 are elevated to the frame 10 through the elevation mechanism 11.
On the other hand, the packing container 4 having the wrapped crucible 2 accommodated therein is transferred by, for example, a transporting conveyor for the packing process. A lid for covering the opening of the container is attached to the container, followed by other operations such as roping the container up, in the packing process, and the container is shipped.

### [Example]

Next, examination is made as to the degree of contamination of a quartz glass crucible in a case where the wrapped quartz glass crucible is packed by using the crane device for a wrapped quartz glass crucible according to the present invention as shown in FIG. 1. Further, as a Comparative Example, similar examination is made as to a case where a wrapped quartz glass crucible of the same type is manually packed by two operators in the conventional manner.

The degree of contamination of each quartz glass crucible is evaluated by: after packing the wrapped quartz glass crucible, taking the quartz glass crucible out of the wrap in a clean room; attaching adhesive tape to the inner surface of the crucible; removing the attached adhesive tape; visually counting the number of contaminants attached to the adhesive portion of the tape; and calculating the average number of contaminants per unit surface area. For evaluation, the degree of contamination in the case where the wrapped quartz glass crucible is packed by the crane device according to the present invention is calculated as a relative value to the degree of contamination in the case where the wrapped quartz glass crucible is manually packed, which is expressed as index value 100. The smaller relative value represents the smaller degree of contamination. The examination results are shown in Table 1.

**[Table 1]**

| | Wrapped quartz glass crucible is packed by using the crane device of the invention | Wrapped quartz glass crucible is manually packed |
|---|---|---|
| Degree of contamination of surface of crucible | 98 | 100 |

As can be clearly understood from the result in Table 1, the contamination of a quartz glass crucible is suppressed, as compared with the conventional manual packing, by using the crane device according to the present invention. Further, laborsaving in packing operation of a quartz glass crucible can be achieved because the quartz glass crucible can be mechanically packed.

## Claims

1. A crane device (1) provided to be capable of making reciprocal movements along a path (6) between a position above a lifting-up point (3) where a wrapped quartz glass crucible (2) is placed and another position above a putting-down point (5) where a packing container (4) is placed and ascending to descending from the path (6) at each of the lifting-up point (3) and the putting-down point (5), comprising:
four arms (17a-17d) extending in the ascend-descend direction and disposed at apexes of a quadrangle such that two arms (17a, 17c; 17b, 17d) paired on a diagonal line of the quadrangle are movable to advance by sliding along the diagonal line to separate from each other; and
a claw (18a-18d) provided at a rear end of each arm (17a-17d) to extend in the advancing direction of the arm.

2. A method of packing a wrapped quartz glass crucible (2) by lifting up the wrapped quartz glass crucible by a crane device (1), moving the crane device to a quadrangular-prism-shaped packing container (4), and lowering the quartz glass crucible (2) inside the packing container (4), comprising:
preparing a crane device (1) having: four arms (17a-17d) extending in the lifting-up direction of the wrapped quartz glass crucible (2) and disposed at apexes of a quadrangle corresponding to the four corners of the packing container (4) such that two arms (17a, 17c; 17b, 17d) paired on a diagonal line of the quadrangle are movable to advance by sliding along the diagonal line to separate from each other; and a claw (18a-18d) provided at a rear end of each arm (17a-17d) to extend in the advancing direction of the arm;
supporting the bottom of the wrapped quartz glass crucible (2) by the claws (18a-18d), while the four arms (17a-17d) are kept in a state not in contact with the wrap of the crucible; and
lifting up and moving the wrapped quartz glass crucible (2) and then putting it down, thereby loading the quartz glass crucible (2) into the packing container (4).

## Patentansprüche

1. Kranvorrichtung (1), die vorgesehen ist, Hin- und Herbewegungen entlang eines Wegs (6) zwischen einer Position oberhalb einer Hubstelle (3), wo ein eingewickelter Quarzglas- Schmelztiegel (2) platziert ist, und einer anderen Position oberhalb einer Ablegestelle (5), wo ein Verpackungsbehälter (4) platziert ist, auszuführen und sich an jeder Hubstelle (3) und Ablegestelle (5) zu/von dem Weg (6) zu heben und zu senken, umfassend:
vier Arme (17a - 17d), die sich in die Hub-/Senkrichtung erstrecken und an Gipfeln eines Vierecks derart angeordnet sind, dass zwei Arme (17a, 17c; 17b, 17d) gepaart auf einer diagonalen Linie des Vierecks beweglich sind, um durch Gleiten entlang der diagonalen Linie vorwärts zu laufen, um sich voneinander zu trennen, und
eine Klaue (18a - 18d), die an einem hinteren Ende jedes Arms (17a - 17d) vorgesehen ist, um sich in die Vorlaufrichtung des Arms zu erstrecken.

2. Verfahren zum Verpacken eines eingewickelten Quarzglas-Schmelztiegels (2) durch Heben des eingewickelten Quarzglas-Schmelztiegels durch eine Kranvorrichtung (1), Bewegen der Kranvorrichtung (1) zu einem Viereck-Prismen-förmigen Verpackungsbehälter (4) und Senken des eingewickelten Quarzglas-Schmelztiegels (2) in das Innere des Verpackungsbehälters (4), umfassend:
Vorbereiten einer Kranvorrichtung (1), die Folgendes hat: vier Arme (17a - 18d), die sich in die Hubrichtung des eingewickelten Quarzglas-Schmelztiegels (2) erstrecken und an Gipfeln eines Vierecks angeordnet sind, die den vier Ecken des Verpackungsbehälters (4) entsprechen, so das zwei Arme (17a, 17c; 17b, 17d) auf einer diagonalen Linie des Vierecks beweglich sind, um durch Gleiten entlang der diagonalen Linie vorwärts zu laufen, um sie voneinander zu trennen, und eine Klaue (18a - 18d), die an einem hinteren Ende jedes Arms (17a - 17d) vorgesehen ist, um sich in die Vorlaufrichtung des Arms zu erstrecken, Stützen des Bodens des eingewickelten Quarzglas-Schmelztiegels (2) und durch die Klauen (18a - 18d), wodurch die vier Arme (17a - 17d) in einem Zustand ohne Berührung mit der Umwicklung des Schmelztiegels gehalten werden, und
Heben und Bewegen des eingewickelten Schmelztiegels und dann sein Absetzen, wodurch der Quarzglas-Schmelztiegel (2) in den Verpackungsbehälter (4) geladen wird.

## Revendications

1. Dispositif de grue (1) conçu pour être capable de faire un mouvement alternatif le long d'une trajectoire (6) entre une position au-dessus d'un point de levage(3), où est placé un creuset en verre de quartz enveloppé (2) et une autre position au-dessus d'un point d'abaissement (5), où est placé un emballage qui monte / descend le long de la trajectoire (6) au niveau du point de levage du plan (3) et du point d'abaissement (5), comprenant :
quatre bras (17a-17d) s'étendant dans la direction ascension-descente et disposés aux sommets d'un quadrilatère, de telle sorte que deux bras (17a, 17c ; 17b, 17d) couplés sur une ligne diagonale du quadrilatère se déplacent pour avancer par coulissement le long de la ligne diagonale et se séparer l'un de l'autre ;
et
une pince (18a-18d) disposée à une extrémité arrière de chaque bras (17a-17d) pour s'étendre à l'avant du bras.

2. Procédé d'emballage d'un creuset en verre de quartz enveloppé (2) en soulevant le creuset en verre de quartz enveloppé grâce à un dispositif de grue (1), en déplaçant le dispositif de grue (1) vers un emballage quadrangulaire en forme de prisme (4), et en abaissant le creuset en verre de quartz (2) à l'intérieur de l'emballage (4), comprenant :
la préparation d'un dispositif de grue (1) possédant: quatre bras (17a-17d) s'étendant dans la direction de levage du creuset en verre de quartz enveloppé (2) et disposés aux sommets d'un quadrilatère correspondant aux quatre coins de l'emballage (4) de telle sorte que deux bras (17a, 17c; 17b, 17d) couplés sur une ligne diagonale du quadrilatère se déplacent pour avancer par coulissement le long de la ligne diagonale et se séparer l'un de l'autre, et une pince (18a à 18d) disposée à une extrémité arrière de chaque bras (17a-17d) pour s'étendre à l'avant du bras ;
le soutien du fond du creuset en verre de quartz enveloppé (2) par des pinces (18a-18d), tandis que les quatre bras (17a-17d) sont maintenus dans un état séparé de l'enveloppe du creuset ; et
le levage et le déplacement du creuset en verre de quartz, puis son abaissement, ce qui permet de charger le creuset en verre de quartz (2) dans l'emballage (4).
